# EUROPEAN PATENT SPECIFICATION

(11) **EP 2 042 614 B1**
(45) Date of publication and mention of the grant of the patent: **13.11.2013**
(21) Application number: 07743114.6
(22) Date of filing: 10.05.2007
(51) Int. Cl.: C22C 14/00, C22F 1/18, C22F 1/00

(54) **HIGH-POWER Ti-Ni-Cu SHAPE MEMORY ALLOY AND PROCESS FOR PRODUCING THE SAME**
HOCHLEISTUNGS-TI-NI-CU-FORMGEDÄCHTNISLEGIERUNG UND HERSTELLUNGSVERFAHREN DAFÜR
ALLIAGE Ti-Ni-Cu À MÉMOIRE DE FORME À HAUTE PUISSANCE ET SON PROCESSUS DE PRODUCTION

(30) Priority: 02.06.2006 JP 2006155385; 11.10.2006 JP 2006277688; 29.01.2007 JP 2007018538
(43) Date of publication of application: 01.04.2009
(73) Proprietor: National Institute for Materials Science, Tsukuba-shi, Ibaraki 305-0047 (JP)
(72) Inventor: ISHIDA, Akira, Tsukuba-shi, Ibaraki 305-0047 (JP); SATO, Morio, Tsukuba-shi, Ibaraki 305-0047 (JP)
(74) Representative: Hall, Matthew Benjamin
(86) International application number: PCT/JP2007/059679
(87) International publication number: WO 2007/141988

(56) References cited:
- CN-A- 1 644 740
- JP-A- 03 082 727
- OTA M. ET AL: 'MA/SPS Process ni yoru Sakusei shita Ti-Ni-Cu-kei Keijo Kioku Gokin no Soshiki' SHUKI JAPAN SOCIETY OF POWDER AND POWDER METALLURGY KOEN GAIYOSHU 1999, page 237, XP008092581
- OGAWA K. ET AL: 'Ti Kajo Ti-Ni-Cu gokin Hakumaku no Bisai Soshiki' THE JAPAN INSTITUTE OF METALS KOEN GAIYOSHU 28 September 2005, page 313, XP008092580
- SATO M. ET AL: '(Ni, Cu) Kajogawa Ti-Ni-Cu Gokin Hakumaku no Hentai Ondo ni Oyobosu Cu-ryo no Koka' THE JAPAN INSTITUTE OF METALS KOEN GAIYOSHU 28 September 2005, page 314, XP008092578

## Description

### Technical Field

The present invention concerns a high power Ti-Ni-Cu shape memory alloy capable of generating a large force, among shape memory alloys, and a production process therefor.

### Background Art

While application use to various technical regions has been studied on shape memory alloys, application of thin films of shape memory alloys to devices has been noted in recent years. For example, they are applied to various forms including micro pumps and valves, as well as limbs of robots and microclips.

With the extension of such applied technical regions, it has been one of major demands in shape memory alloys to develop those providing larger actuating forces as an actuator in any of bulk form or thin film form.

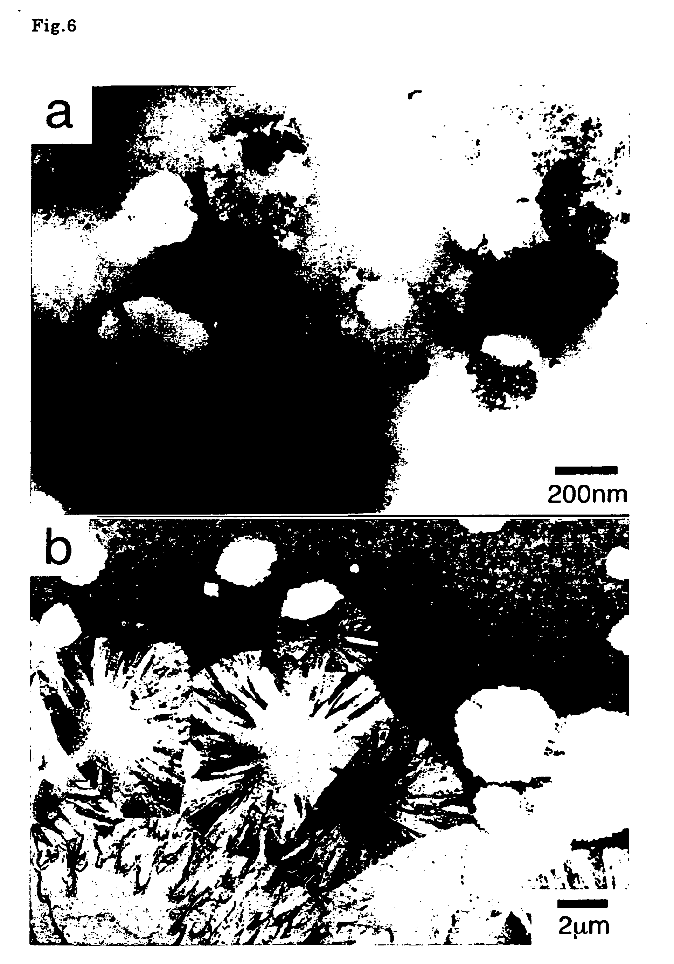

As the shape memory alloy, while those having Ti-Ni based compositions have been known typically so far, none of them was satisfactory with a view point of attaining a larger actuating force. For example, "a Ti-Ni shape memory alloy having a composition with a titanium content of from 50 to 66 at% characterized in that precipitates of nanometer scale are formed and distributed by a heat treatment at 600 to 800K for an amorphous alloy" has been known (Patent Document 1), and it is described that the shape recovery force (identical with actuating force) can be improved remarkably. However the obtained actuating force is about 250 MPa as apparent from the example (Fig. 6) thereof.

Further, a Ti-Zr-Ni based shape memory thin film with addition of Zr to Ti-Ni is also proposed (Patent Document 2).

However, while it is described that the crystal grain therein can be refined therein, it has a drawback that the temperature hysteresis is large and undergoes a restriction not suitable to an actuator that operates near a room temperature since the transformation temperature is 100°C or higher.

On the other hand, since a Ti-Ni-Cu alloy has a small temperature hysteresis and the transformation temperature is about a room temperature, it is expected as being suitable to the application use as an actuator. For such a Ti-Ni-Cu based shape memory alloy, a production process for a Ti-Ni-Cu alloy containing 10 at% or more of Cu, which is difficult to be worked by a usual melting-hot process has been known (Patent Document 3). However, the compositional range thereof is restricted to a single phase region near 50% Ti and the actuating force is small. This intends to decrease the temperature hysteresis and the transformation temperature range by obtaining a columnar crystals of aligned crystal direction by structure control during solidification.

Under the situation described above, the present inventors have attained an alloy in which precipitates of a Ti-Ni-Cu phase or a Ti-Cu phase of 500 nm or less in TiNi grains with a grain size of 2 µm or less by conducting a heat treatment at 500 to 700°C up to 100 hr on a Ti-Ni-Cu ternary amorphous alloy with the Ti content of from 44 to 49 at%, the Cu content of from 20 to 30 at%, and the balance of Ni and obtained a transformation temperature and an actuating force of from 300 to 600 MPa over a wide compositional range (Japanese Patent Application No. 2005-172939).

While this enables to attain higher actuating force than the existent Ti-Ni-Cu alloys, it is still about 600 MPa.
Patent Document 1: JP No. 28996822
Patent Document 2: JP-A No. 2002-285275
Patent Document 3: JP-A No. H06-172886

JP-A-3/82727 discloses further Ti-Ni-Cu shape memory alloys.

### Disclosure of the Invention

### Problem to be Solved by the Invention

With the background as described above, the present invention has an object of further developing the study so far on the Ti-Ni-Cu alloy by the present inventors and provides a new high-power Ti-Ni-Cu shape memory alloy producing a higher actuating force, particularly, an outstandingly higher actuating force of 1 GPa or more, capable of being produced by a simple and convenient method, and also stable in view of the transformation temperature, as well as a production process therefor.

### Means for Solving the Problem

The present invention has the following features for attaining the object described above.

First: A Ti-Ni-Cu shape memory alloy in which the composition comprises a Ti content of from 50.5 to 66.6 at%, a Cu content of from 27 to 40 at% and the balance of Ni, and the structure has Ti-Cu crystal grains and TiNi crystal grains, and that the average grain size of TiNi crystal grains is 500 nm or less.

Second: The Ti-Ni-Cu shape memory alloy in which the structure has a Ti₂Cu precipitation phase in TiNi crystal grains together with TiCu crystal grains and TiNi crystal grains.

Third: A process for producing a Ti-Ni-Cu shape memory alloy of applying a heat treatment to crystallize a Ti-Ni-Cu amorphous alloy in which the composition comprises from 50.5 to 66.6 at% of Ti content, from 27 to 40 at% of Cu content, and the balance of Ni.

Fourth: The process for producing a Ti-Ni-Cu shape memory alloy of applying the heat treatment at a temperature of from 450 to 700°C within 100 hr.

### Effect of the Invention

According to the first invention as described above, an actuating force exceeding 1 GPa can be attained.

This is the highest actuating force among the shape memory alloys reported so far. Since it shows the highest actuating force also as a microactuator, an application use as a high power actuator is expected. While the amount of displacement is relatively small, the displacement amount is still about ten times that of piezoelectric actuators and about twice that of the shape memory alloys utilizing R phase transformation put to practical use and it is applicable to an application requiring particularly large force.

Then, according to the second invention, the excellent effect as described above can be attained more reliably and remarkably. According to the third invention, a practical ductility can be obtained.

Further, according to the fourth and the fifth inventions, the high power shape memory alloy as described above can be reliably produced conveniently.

### Brief Description of Drawings

[Fig. 1] Fig. 1 is a graph showing shape memory characteristics of (a) 48.5 at% Ni - 51.5 at% Ti alloy thin film and (b) 18.2 at% Ni - 54.2 at% Ti - 27.6 at% Cu alloy thin film.
[Fig. 2] Fig. 2 is a diagram showing the effect of the Cu content (at%) and the heat treatment temperature on the actuating force of a Ti-Ni-Cu thin film (heat treatment time: 1h, Ti amount 51.5%, 52.5% only for 27.5% Cu alloy) in which () in the diagram shows a case of varying the Ti amount or the heat treatment time.
[Fig. 3] Fig. 3 shows bright field microscopic images showing the effect of the Cu content to the crystal grain size of the Ti-Ni-Cu alloy thin film (Ti amount: 51.5 at%, after heat treatment at 500°C for 1 hr), which shows a case of Cu at% of (a) 15.4 and (b) 23.4.
[Fig. 4] Fig. 4 shows bright field microscopic images showing the effect of the Cu content to the crystal grain size of the Ti-Ni-Cu alloy thin film (Ti content: 51.5 at%, after heat treatment at 500°C for 1h), which shows a case where Cu at% is (c) 27.6 and (d) 33.1.
[Fig. 5] Fig. 5 is an X-ray diffraction diagram for an Ni-Cu-51.5 at% Ti alloy thin film.
[Fig. 6] Fig. 6 shows bright field microscopic images showing the difference of crystallization process between (a) Ti_{51.2}Ni_{15.7}Cu_{33.1} thin film and (b) Ti_{51.8}Ni_{48.2} thin film.
[Fig. 7] Fig. 7 shows bright field microscopic images showing the structure after heat treatment at 700°C for 1h on a Ti_{51.3}Ni_{21.1}Cu_{27.6} thin film.

### Best Mode for Carrying Out the Invention

The present invention has the features as described above and the embodiment is to be described below.

At first, in the Ti-Ni-Cu shape memory alloy of the invention, an extremely high actuating force is a remarkable characteristic thereof and "actuating force" is defined as a force measured by the following method.

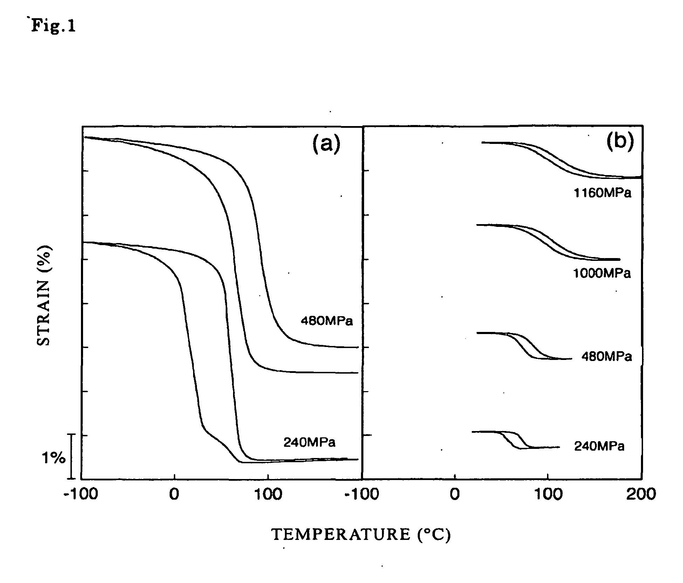

That is, as shown in the appended Fig. 1, cooling-heating is conducted in a state of applying a constant load to measure the generation of a transformation strain by forward transformation (upon cooling) and recovery from the strain by reverse transformation (during heating), and a stress at which the strain remaining with no recovery exceeds 0.02% is defined as "actuating force".

Then, referring to the composition of the Ti-Ni-Cu shape memory alloy of the invention, it comprises
Ti content of: from 50.5 to 66.6 at%
Cu content of: from 27 to 40 at%
Ni content of: balance
as described above and the reason for the definition thereof in view of the crystal structure is as described below.

In a case where the Cu content does not exceed 27 at%, no sufficient TiCu crystal grains refined for the improvement of the actuating force can be obtained and, when it exceeds 40 at%, although TiCu crystal grains are increased, TiNi crystal grains responsible to the shape memory effect are decreased and the displacement amount is decreased extremely (0.2% or less), which is no more practical.

Further, it is considered that the improvement in the actuating force of the alloy of the invention is mainly attributable to the refinement strengthening of the TiNi crystal grains by the mixing of the TiCu crystal grains. However, refinement of crystal grains increases the grain boundary to lower the ductility. Then, for obtaining a practical ductility, it is desired to precipitate Ti₂Cu in the TiNi grains at the same time with the refinement of the crystal grains to suppress stress concentration to the grain boundary. Further, precipitation of Ti₂Cu in the grain also has an effect of promoting the refinement of the crystal grain. Accordingly, with a view point that precipitation of the Ti₂Cu phase is desirable, the Ti content is defined as from 50.5 to 66.6at%.

The Ni content is defined as the balance for the containment ratio of Cu and Ti described above. Needless to say, containment of inevitable impurities intruding in the starting material of the Ti, Cu and Ni, and in the production process are allowed in the composition of the invention.

Then, the alloy of the invention has TiCu crystal grains and TiNi crystal grains that constitute the structure respectively, and "has" referred to herein means that the presence thereof is confirmed at least by X-ray diffraction.

The average grain size of each of the crystal grains is preferably less than 1 µm. Further, for the improvement of the actuating force, it is desired that the average crystal grain size of TiNi responsible to the shape memory effect is 500 nm or less. In a case where the average grain size is larger than 500 nm, no remarkable increase for the actuating force can be expected in the Ti-Ni-Cu based alloy.

In the crystal structure of the alloy of the invention, the TiCu phase is present in admixture so as to surround the TiNi phase as a more preferred form, which presents the feature that the growth of the TiNi crystal grains is inhibited to provide refinement.

It is considered that the fine structure according to the invention as described above is due to the specific nucleation and growing process upon crystallization from an amorphous phase.

Also with the reason described above in the invention, a Ti-Ni-Cu shape memory alloy is prepared by crystallization of a Ti-Ni-Cu amorphous alloy by a heat treatment as described above. In this case, the Ti-Ni-Cu amorphous alloy can be prepared by various kinds of methods as the composition having Ti,Cu,Ni as described above. For example, it may be a film form by a vapor deposition method by sputtering or the like, a ribbon-like shape by a single roll or twin roll method, or various other forms.

The amorphous alloy prepared by the methods described above are heat treated and crystallized.

The crystallization temperature of the alloy according to the invention is just below 450°C and it is not crystallized unless it is at 450°C or higher. Further, for obtaining a large actuating force, the average grain size of the crystals is less than 1 µm and, further, 500 nm or less. Accordingly, growing of crystal grains by an excess heat treatment, for example, a heat treatment at a high temperature of 700°C or higher has to be avoided.

Also for the time of the heat treatment, it is usually preferred not to exceed 100 hr with a view point of avoiding the excess heat treatment.

The method of the heat treatment can, for example, be a method of heating in a heating furnace such as by infrared lamps, and the atmosphere may be under vacuum reduced pressure or in an inert gas atmosphere such as of argon. Cooling may be furnace cooling maintaining a vacuum atmosphere with no exposure to atmospheric air or cooling or quenching in and an inert gas atmosphere.

The average grain size of the crystals in the invention is generally defined as that by a method of distinguishing individual crystal grains on an electron microscopic photograph (bright field images), as a circular form as an average value for diameters which are determined while assuming the form of crystals as a circle estimated to cover the planar area thereof (measured for crystal grains at least by the number of 100).

Then, examples are shown below and description is to be made more specifically. Of course, the invention is not restricted by the following examples.

### Example

In the following table, the composition, the sputtering conditions, the heat treatment conditions, slip critical stress, and crystal grain size of the alloy thin films shown by the examples are arranged in the table on every examples.

**[Table 1]**

| Experiment No. | Substrate material | Sputter deposition | | | | | | Film ingredient (at%) | | |
|---|---|---|---|---|---|---|---|---|---|---|
| | | Vacuum degree × 10⁻⁵Pa | Gas | Pa | Substrate temperature × 10² °C | Deposition time × 10 min | Thin film thickness µm | Ni | Ti | Cu |
| (1) | | | | | | | | | | |
| 1-1 | Glass plate | 3 | Ar | 0.2 | 2 | 15 | 8 | 18.2 | 54.2 | 27.6 |
| 1-2 | " | " | " | " | " | " | " | 48.5 | 51.5 | - |

| (2) | | | | | | | | | | |
|---|---|---|---|---|---|---|---|---|---|---|
| 2-11 | Glass plate | 3 | Ar | 0.2 | 2 | 15 | 8 | 25.2 | 51.4 | 23.4 |
| 2-12 | " | " | " | " | " | " | " | " | " | " |
| 2-13 | " | " | " | " | " | " | " | " | " | " |
| 2-21 | " | " | " | " | " | " | " | 21.1 | 51.3 | 27.6 |
| 2-22 | " | " | " | " | " | " | " | " | " | " |
| 2-23 | " | " | " | " | " | " | " | " | " | " |
| 2-24 | " | " | " | " | " | " | " | " | " | " |
| 2-31 | " | " | " | " | " | " | " | 15.7 | 51.2 | 33.1 |
| 2-32 | " | " | " | " | " | " | " | " | " | " |
| 2-33 | " | " | " | " | " | " | " | " | " | " |
| 2-34 | " | " | " | " | " | " | " | " | " | " |
| 2-35 | " | " | " | " | " | " | " | " | " | " |
| 2-41 | | | | | " | | | 11.3 | 51.4 | 37.3 |
| 2-42 | | | | | " | | | " | " | " |
| 2-43 | | | | | " | | | " | " | " |
| 2-5 | " | " | " | " | " | " | " | 16.2 | 55.8 | 28.0 |
| 2-6 | " | " | " | " | " | " | " | 12.5 | 54.6 | 32.9 |

| (3) | | | | | | | | | | |
|---|---|---|---|---|---|---|---|---|---|---|
| 3-1 | Glass plate | 3 | Ar | 0.2 | 2 | 15 | 8 | 33.1 | 51.5 | 15.4 |
| 3-2 | " | " | " | " | " | " | " | 25.2 | 51.4 | 23.4 |
| 3-3 | " | " | " | " | " | " | " | 21.1 | 51.3 | 27.6 |
| 3-4 | " | " | " | " | " | " | " | 15.7 | 51.2 | 33.1 |
| (1): Refer to Fig. 1, Experimental example corresponding to Example 1 | | | | | | | | | | |
| (2): Refer to Fig. 2, Experimental example corresponding to the former half of Example 2 | | | | | | | | | | |
| (3): Refer to Figs. 3,4, Experimental example corresponding to the latter half of Example 2 | | | | | | | | | | |

**[Table 2]**

| Experiment No. | Heating source | Heat treatment | | | | Result | | Remark |
|---|---|---|---|---|---|---|---|---|
| | | Vacuum degree × 10⁻⁵Pa | Temperature × 10² °C | Atmosphere | Time Hour | Limit stress GPa | TiNi phase average grain size µm | |
| (1) | | | | | | | | |
| 1-1 | IR ray | 2.7 | 5 | In vacuum | 1 | | | |
| 1-2 | " | " | 5 | " | 1 | | | Comp. Example |

| (2) | | | | | | | | |
|---|---|---|---|---|---|---|---|---|
| 2-11 | IR ray | 2.7 | 5 | In vacuum | 1 | 0.64 | 0.8 | Comp. Example |
| 2-12 | " | " | 6 | " | 1 | 0.4 | 1.0 | Comp. Example |
| 2-13 | " | " | 7 | " | 1 | 0.24 | 1.0 | Comp. Example |
| 2-21 | " | " | 4.5 | " | 1 | 1 or more | 0.3 | |
| 2-22 | " | " | 5 | " | 1 | 1 or more | 0.3 | |
| 2-23 | " | " | 6 | " | 1 | 0.88 | 0.3 | |
| 2-24 | " | " | 7 | " | 1 | 0.48 | 0.7 | |
| 2-31 | " | " | 5 | " | 1 | 1 or more | 0.2 | |
| 2-32 | " | " | 7 | " | 1/60 | 1 or more | - | |
| 2-33 | " | " | 6 | " | 1 | 1 or more | 0.2 | |
| 2-34 | " | " | 7 | " | 1 | 0.76 | 0.6 | |
| 2-35 | " | " | 5 | " | 100 | 1 or more | - | |
| 2-41 | " | " | 5 | " | 1 | 1 or more | - | |
| 2-42 | " | " | 6 | " | 1 | 1 or more | - | |
| 2-43 | " | " | 7 | " | 1 | 1 or more | - | |
| 2-5 | " | " | 6 | " | 1 | 1 or more | - | |
| 2-6 | " | " | 6 | " | 1 | 1 or more | - | |

| (3) | | | | | | | | |
|---|---|---|---|---|---|---|---|---|
| 3-1 | IR ray | 2.7 | 5 | In vacuum | 1 | 0.44 | 1.5 | Comp. Example |
| 3-2 | " | " | 5 | " | 1 | 0.64 | 0.8 | Comp. Example |
| 3-3 | " | " | 5 | " | 1 | 1 or more | 0.3 | |
| 3-4 | " | " | 5 | " | 1 | 1 or more | 0.2 | |
| (1): Refer to Fig. 1, Experimental example corresponding to Example 1 | | | | | | | | |
| (2): Refer to Fig. 2, Experimental example corresponding to the former half of Example 2 | | | | | | | | |
| (3): Refer to Figs. 3,4, Experimental example corresponding to the latter half of Example 2 | | | | | | | | |

### <Example 1>

A thin film of a 18.2 at%Ni-54.2 at%Ti-27.6 at%Cu alloy was manufactured under the following conditions by using a multiple magnetron sputtering apparatus.

That is, by using a glass plate as a substrate, sputtering was conducted by introducing an Ar gas at 0.2 Pa after evacuation to 3 × 10⁻⁵ Pa. Film formation was conducted at a substrate temperature of 200°C for 150 min to obtain a thin film of about 8 µm thickness.

After film formation, a thin film was peeled from the substrate, applied with a heat treatment in an infrared vacuum heating furnace (vacuum degree: 2.7 × 10⁻⁵ Pa) and cooled by introducing an Ar gas.

The composition was analyzed for the thin film by ICP emission spectroscopy.

On the other hand, a thin film of a 48.5 at%Ni-51.5 at%Ti alloy was manufactured in accordance with the Patent Document 1 (JP No. 2899682).

The shape memory characteristics were evaluated for each of the alloy thin films described above and Fig. 1 shows the result.

For the measurement of the actuating force, cooling and heating were conducted in a state of applying a constant load and a stress at the limit where the strain (0.02%) started to remain with no complete recovery for transformation strain was defined as an actuating force.

From Fig. 1, a large residual strain is recognized to a force at 480 MPa in a 48.5 at%Ni-51.5 at%Ti alloy, it can be seen that 18.2 at%Ni-54.2 at%Ti-27.6 at%Cu alloy thin film shows a complete shape memory effect also to the load stress of 1 GPa or more and a large actuating force is obtained.

### <Example 2>

In the same manner as in Example 1, amorphous alloy thin films of: 33.1 at%Ni-15.4 at%Cu-51.5 at%Ti; 25.2 at%Ni-23.4 at%Cu-51.4 at%Ti; 21.1 at%Ni-27.6 at%Cu-51.3 at%Ti; 15.7 at%Ni-33.1 at%Cu-51.2 at%Ti; 11.3 at%Ni-37.3 at%Cu-51.4 at%Ti; 16.2 at%Ni-28 at%Cu-55.8 at%Ti, and 12.5 at%Ni-32.9 at%Cu-54.6 at%Ti were manufactured. After peeling the obtained thin films from the substrate, a heat treatment at 450 to 700°C was conducted.

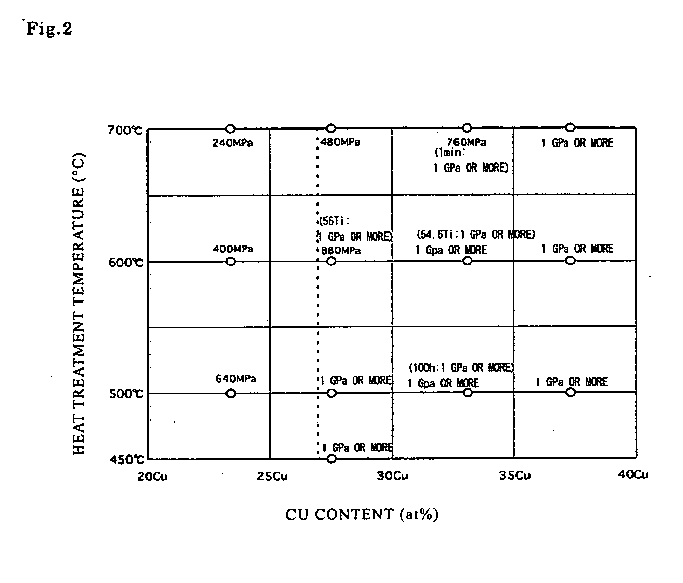

Fig. 2 shows the effect of the composition and the heat treatment to the actuating force. It has been found that in a case where the Cu content is less than 27 at%, only the actuating force of about 600 MPa is obtained, but an actuating force exceeding 1 GPa is obtained at 27% or more. It has been found that increase in the Ti content additionally contributes to the increase of the actuating force although this is not so much as in the case of the Cu amount.

While the actuating force is 480 MPa for a Cu-27.6 at% alloy in a case of a heat treatment temperature of 700°C, but the actuating force is improved greatly by controlling the Ti amount as in the case of the heat treatment at 600°C, or by controlling the heat treatment time in a case of the Cu 33.1 at% alloy.

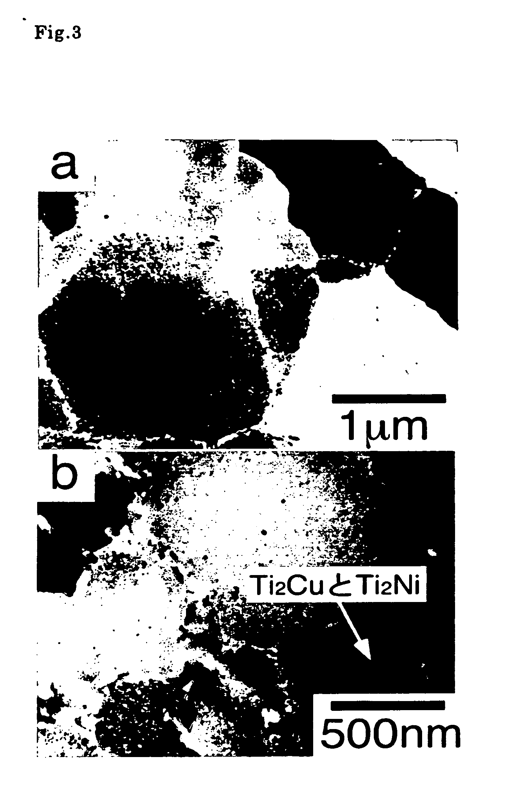

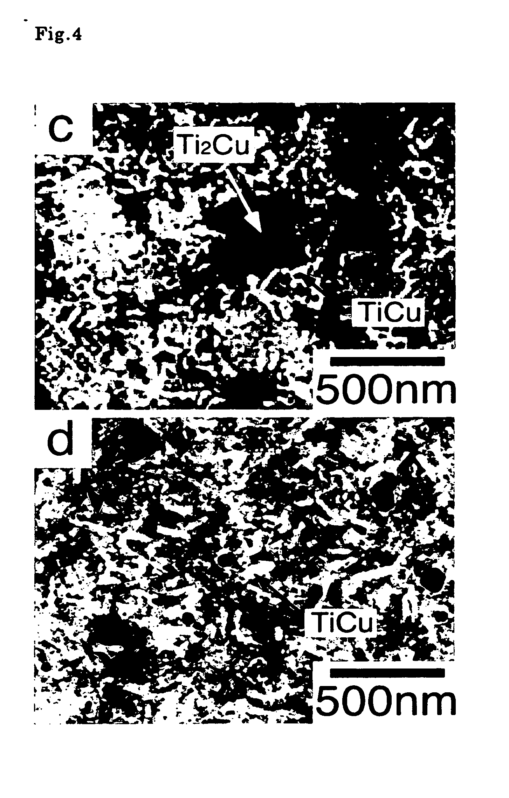

Further, Figs. 3 and 4 show the effect of the Cu content on the thin film structure.

Figs. 3, 4 show the effects in the case where Cu at% is (a) 15.4, (b) 23.4, (c) 27.6, and (d) 33.1.

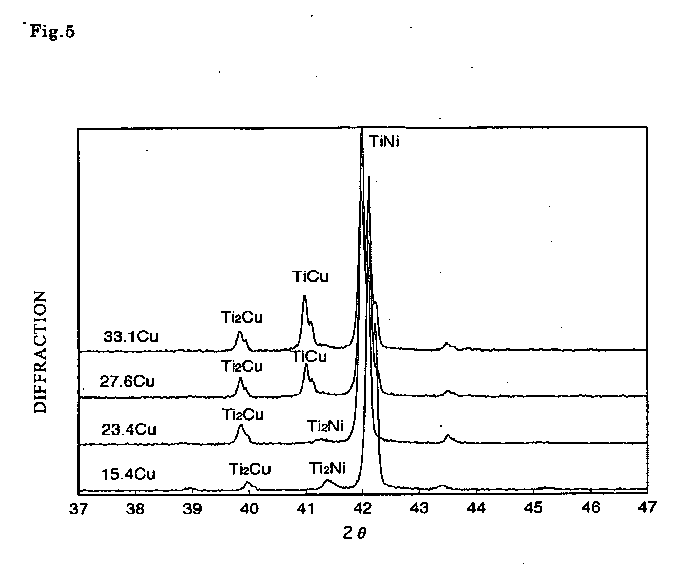

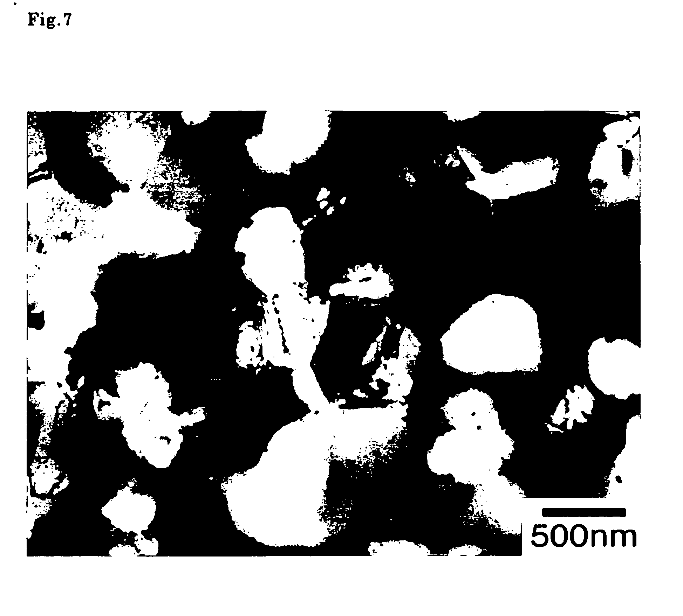

As apparent from Figs. 3, 4, it can be seen that the crystal grain size is decreased remarkably and the average grain size of the TiNi crystals is 500 nm or less in the alloy thin film containing 27 at% or more of Cu. In the alloy films, a TiCu phase is recognized as the second phase and, since the phase is not present in the TiNi grain as in the Ti₂Cu phase or Ti₂Ni but is present along the grain boundaries, it provides a structure in which fine TiCu crystals and TiNi crystals are mixed. Fig. 5 shows the result of X-ray diffraction and it has been found that the TiCu phase is recognized only for the alloy containing Cu by 27 at% or more. Fig. 6 shows the crystallizing process of the Ti_{51.2}Ni_{15.7}Cu_{33.1} (at%) thin film. In the Ti_{51.2}Ni_{15.7}Cu_{33.1} thin film, the size for each of the crystal grains precipitated from the amorphous phase is about 300 nm and the grain size is uniform. However, in the Ti_{51.8}Ni_{48.2} thin film shown as the comparative example, the crystal grain is rapidly grown to about 5 µm and, accordingly, the size of the crystal grains is not uniform. In the Ti_{51.2}Ni_{15.7}Cu_{33.1} thin film, it is estimated that the Cu content is increased at the periphery of the nucleated TiNi crystal grains due to Cu discharged from the TiNi phase and the TiCu phase is formed in the succeeding process of the heat treatment. Since formation of the TiCu phase suppresses the growth of TiNi crystal grains, a structure in which the TiNi crystal grains and the TiCu crystal grains are mixed finely is obtained as a result. The obtained structure is stable under a relatively wide heat treatment conditions, and shows high actuating force of about 1 GPa as shown in Fig. 2. However, when the crystal grain is grown as far as 500 nm or more by an excess heat treatment, as shown in Fig. 7, since the actuating force is lowered as apparent from Fig. 2, it is preferred to avoid a heat treatment at high temperature for long time.

## Claims

1. A Ti-Ni-Cu shape memory alloy with a composition that comprises a Ti content of from 50.5 to 66.6 at%, a Cu content of from 27 to 40 at%, and the balance of Ni, **characterised in that** its structure has TiCu crystal grains and TiNi crystal grains, and that the average grain size of the TiNi crystal grains is 500 nm or less.

2. The Ti-Ni-Cu shape memory alloy according to claim 1 **characterized in that** the structure has a Ti₂Cu precipitation phase in the TiNi crystal grains, together with the TiCu crystal grains and the TiNi crystal grains.

3. A process for producing a Ti-Ni-Cu shape memory alloy according to claim 1 or 2, **characterized by** heat treating and crystallizing a Ti-Ni-Cu amorphous alloy in which a composition comprises a Ti content of from 50.5 to 66.6 at%, a Cu content of from 27 to 40 at%, and the balance of Ni.

4. The process for producing a Ti-Ni-Cu shape memory alloy **characterized by** applying heat treatment at a temperature from 450 to 700°C and within a time

## Patentansprüche

1. Ti-Ni-Cu-Formgedächtnislegierung mit einer Zusammensetzung, die einen Ti-Gehalt von 50,5 bis 66,6 AT%, einen Cu-Gehalt von 27 bis 40 AT% aufweist und der Rest aus Ni besteht, **dadurch gekennzeichnet, dass** ihre Struktur TiCu-Kristallkörner und TiNi-Kristallkörner aufweist und dass die durchschnittliche Korngröße der TiNi-Kristallkörner 500 nm oder weniger beträgt.

2. Ti-Ni-Cu-Formgedächtnislegierung nach Anspruch 1, **dadurch gekennzeichnet, dass** die Struktur eine Ti₂Cu-Ausfällimgsphase in den TiNi-Kristallkörnern zusammen mit den TiCu-Kristallkörnern und den TiNi-Kristall-körnern aufweist.

3. Verfahren zur Herstellung einer Ti-Ni-Cu-Formgedächt-nislegierung nach Anspruch 1 oder 2, **gekennzeichnet durch** Hitzebehandeln und Kristallisieren einer amorphen Ti-Ni-Cu-Legierung, wobei eine Zusammensetzung einen Ti-Gehalt von 50,5 bis 66,6 AT%, einen Cu-Gehalt von 27 bis 40 AT% aufweist und der Rest aus Ni besteht.

4. Verfahren zur Herstellung einer Ti-Ni-Cu-Formge-dächtnislegierung, **gekennzeichnet durch** das Anwenden einer Hitzebehandlung bei einer Temperatur von 450 bis 700 °C und innerhalb einer Zeit von 100 h.

## Revendications

1. Alliage à mémoire de forme de Ti-Ni-Cu avec une composition qui comprend 50,5 à 66,6 % d'atomes de Ti, 27 à 40 % d'atomes de Cu de et le reste de Ni, **caractérisé en ce que** sa structure a des grains cristallins de TiCu et des grains cristallins de TiNi, et **en ce que** la taille de grain moyenne des grains cristallins de TiNi est de 500 nm ou moins.

2. Alliage à mémoire de forme de Ti-Ni-Cu selon la revendication 1, **caractérisé en ce que** la structure a une phase de précipitation de Ti₂Cu dans les grains cristallins de TiNi, en même temps que les grains cristallins de TiCu et les grains cristallins de TiNi.

3. Processus pour produire un alliage à mémoire de forme de Ti-Ni-Cu selon la revendication 1 ou 2, **caractérisé par** un traitement thermique et la cristallisation d'un alliage amorphe de Ti-Ni-Cu dans lequel une composition comprend 50,5 à 66,6 % d'atomes de Ti, 27 à 40 % d'atomes de Cu et le reste de Ni.

4. Processus pour produire un alliage à mémoire de forme de Ti-Ni-Cu **caractérisé par** l'application d'un traitement thermique à une température de 450 à 700 °C et dans un temps de 100 heures.
